# EUROPEAN PATENT APPLICATION

(11) **EP 4 443 299 A1**
(43) Date of publication of application: **09.10.2024**
(21) Application number: 23217011.8
(22) Date of filing: 15.12.2023
(51) Int. Cl.: G06F 11/26, G06F 11/36, G06F 30/20, G06F 11/22, G06F 11/34

(54) **VIRTUALIZED EXTENSIBLE HARDWARE SIMULATION FRAMEWORK**

(30) Priority: 07.04.2023 US 202318132138
(71) Applicant: Google LLC, Mountain View, CA 94043 (US)
(72) Inventor: CONNOR, Larry L., Mountain View, 94043 (US); FOLEY, Peter Edmund, Mountain View, 94043 (US); RAO, Shiva, Mountain View, 94043 (US); VENTURE, Patrick Shawn, Mountain View, 94043 (US); RAUER, Christopher Michael Rowett, Mountain View, 94043 (US); JANNI, Daniel, Mountain View, 94043 (US)
(74) Representative: Betten & Resch

(57) **Abstract**

Generally disclosed herein is a customizable hardware simulation framework implemented with configurable modules to allow for flexible fidelity. The hardware simulation framework may configure various components of the system to be either simulated, emulated, or real. The flexibility in this reconfigurability may provide means to balance the velocity and accuracy of each component's performance. The system allows developers to use upper-level software that relies on the system software in a manner that appears identical to the underlying physical hardware. Moreover, the components of the system may interact via remote procedure calls (RPC) even though the components were originally constructed in different manners using different languages.

## Description

### BACKGROUND

Typically, when new hardware or platforms are developed, new software to utilize the hardware needs to be developed such that the new hardware functionality is correctly linked to the application layer's software components. Since there is usually a close link between the software components and the underlying hardware, it may be challenging to correctly develop the respective software prior to the completion of building the underlying hardware.

Additionally, testing the software on early versions of the underlying hardware may have several problems. For example, waiting until building the underlying hardware is completed, and the underlying hardware is stable to begin the software development may cause significant market delays. It may also be costly to identify problems in the underlying hardware or any linked software in the late stage of development if the problems require changes in the underlying hardware/firmware. Moreover, the early versions of hardware may contain significant electrical issues and manufacturing defects that manifest as software errors. These types of problems are difficult and costly to detect and mitigate. Further, the early versions of hardware may be in short supply and the cost of obtaining the hardware may be high as the production has not yet scaled.

There are some known technologies to address the above issues. However, such technologies typically suffer from issues such as preset fidelity levels of the simulated hardware devices, limited source and language handling, simulation scaling limitations, and a limited capability to integrate simulated hardware devices with a production software (SW) stack.

### BRIEF SUMMARY

The technology generally relates to a customizable hardware simulation framework with configurable modules that allow for flexible fidelity of hardware simulations. The framework provides hardware-free software development and testing for new hardware products in development. The technology may include virtual machines (VM), a virtual machine orchestrator, component-level HW simulations of varying fidelity, an entity-relationship model that describes the hardware, a simulation builder driven by said model and integrations into a distributed production SW stack and network. The technology also provides a user interface to arrange a mixed-fidelity hardware simulation, with the fidelity of each simulation of a hardware component capable of being selected independently. The technology also provides for partial hardware system simulation as well as whole hardware system simulation depending on the needs of the use case, such as faster, less precise (lower fidelity), or slower (higher fidelity) simulations. As used herein, a hardware system is a structure comprising any number of hardware components. In this regard, a hardware system may refer to one hardware component, more than one hardware component, or sub-components used to form a hardware component or multiple hardware components. It is also to be understood that for the purpose of the present disclosure, hardware and component will be used interchangeably and refer to a component of the hardware system.

An aspect of the disclosure provides for hardware simulation framework comprising one or more computing devices configured to determine a plurality of hardware devices for testing using simulation, enable a user to select a level of fidelity of the simulation for each of the plurality hardware devices, and simulate each of the plurality of hardware devices based on the selected level of fidelity.

In another example, the system further comprises a plurality of virtual machines and a virtual machine orchestrator.

In yet another example, the level of fidelity of the simulation for each of the plurality of hardware devices is determined based on desired processing speed and accuracy of the simulation of each hardware device.

In yet another example, the fidelity levels are changed using a graphical user interface or text files.

In yet another example, the system further comprises an entity-relationship model, wherein the entity-relationship model describes configurations of the plurality of hardware devices.

In yet another example, the system further comprises a simulation builder, wherein the simulation builder automatically simulates each of the plurality of hardware devices based on the entity-relationship model.

In yet another example, the simulated each of the plurality of hardware devices are integrated into a distributed production software stack and network.

In yet another example, each of the simulated hardware devices mimic functions of each of the hardware devices.

In yet another example, each of the simulated hardware devices are either partially simulated or fully simulated.

In yet another example, the simulated hardware devices are connected to the hypervisor via an application programming interface (API) layer.

In yet another example, each of the virtual machines is either a persistent virtual machine or a transitory virtual machine.

In yet another example, the virtual machine orchestrator utilizes a remote procedure call (RPC) to enable interaction between the plurality of virtual machines using different languages in different manners.

In yet another example, the virtual machine orchestrator communicates with one or more simulated hardware devices using smart network interface cards in the network, wherein the smart network interface cards can be simulated based on a user selection.

In yet another example, the virtual machine orchestrator provides a configurable level of abstraction, for the simulation.

In yet another example, the virtual machine orchestrator is further configured to inject deterministic errors of the hardware devices into the simulated hardware devices for testing errors.

In yet another example, the virtual machine orchestrator is further configured to simulate a baseboard management controller to manage a physical state of the hardware devices.

In yet another example, the physical state of the hardware devices comprises temperature, humidity, power supply voltage, fan speeds, remote access, and operating system functions of the underlying hardware.

Another aspect of the disclosure provides for a method for hardware simulation framework. The method includes determining, by one or more processors, a plurality of hardware devices for testing using simulation. The method also includes enabling, by the one or more processors, a user to select a level of fidelity of the simulation for each of the plurality hardware devices. The method further includes simulating, by the one or more processors, each of the plurality of hardware devices based on the selected level of fidelity.

In another example, the level of fidelity of the simulation for each of the plurality of hardware devices is determined based on desired processing speed and accuracy of the simulation of each hardware device.

In yet another example, the fidelity levels are changed using a graphical user interface or text files.

### BRIEF DESCRIPTION OF THE DRAWINGS

FIG. 1 depicts a high-level architecture of an example virtualized extensible hardware simulation configuration on a distributed network according to aspects of the disclosure.
FIG. 2 depicts an example virtualized extensible hardware simulation environment interconnecting multiple storage devices in a cloud environment according to aspects of the disclosure.
FIG. 3 depicts a block diagram of an example emulation of a baseboard management controller (BMC) according to aspects of the disclosure.
FIG. 4A depicts a flow diagram of example functional tests using real hardware according to aspects of the disclosure.
FIG. 4B depicts a flow diagram illustrating the development of underlying hardware using an emulator and a virtual machine according to aspects of the disclosure.
FIG. 5 depicts a flow diagram illustrating an example simulation of a host machine according to aspects of the disclosure.
FIG. 6 illustrates a computing device according to the aspects of the disclosure.
FIG. 7 depicts a flow diagram of an example method for hardware simulation according to the aspects of the disclosure.

### DETAILED DESCRIPTION

Generally disclosed herein is a customizable hardware simulation framework that may be implemented with configurable modules to allow for flexible fidelity. The hardware simulation framework may configure various components of the hardware system being modeled to be simulated or emulated. In some instances, the simulation framework may also provide for the simulation to include the use of physical hardware components. The flexibility in the above configurability may provide the capability to balance the speed and accuracy of each component's performance. In one example, the hardware simulation framework comprises software modules that model hardware interactions via a generic API layer that may be linked to the virtual machine. The hardware system-level software including kernel and driver-level software may be allowed to run on the framework that was specifically developed for a new platform. The hardware simulation framework allows developers to use upper-level software that relies on the hardware system software in a manner that appears identical to the underlying physical hardware. Moreover, the components of the hardware system may interact via remote procedure calls (RPC) even when the components were originally constructed in different manners using different languages.

In one aspect, a customizable hardware simulation framework implemented with configurable modules to allow for flexible fidelity is disclosed. The hardware simulation framework may configure various components of the system to be either simulated, emulated, or real. The flexibility in this reconfigurability may provide means to balance the velocity and accuracy of each component's performance. The system allows developers to use upper-level software that relies on the system software in a manner that appears identical to the underlying physical hardware. Moreover, the components of the system may interact via remote procedure calls (RPC) even though the components were originally constructed in different manners using different languages.

It is to be understood that for the purpose of describing the present disclosure, emulation may refer to the emulation of hardware using programmable hardware, such as FPGAs. These hardware emulators may execute real software binaries. Simulation may refer to any type of software-based simulation of hardware components. Hardware emulators typically provide higher fidelity than software-based simulators, however, simulators, such as those that are configured to run firmware, may have similar, or even higher, fidelity than hardware emulators. For clarity, the term "simulation," as used herein, will refer to both emulators and simulators. The term "fidelity," as used herein, will refer to the similarity between the simulator and the physical component being simulated. In this regard, high fidelity refers to simulators that accurately model the entire operation of the physical component whereas lower fidelity simulators have less accuracy with at least portions of the operation of the physical component. It should be understood that some simulators may model a portion of a hardware component with higher accuracy (higher fidelity) than other portions of the hardware component (lower fidelity) creating a level of fidelity somewhere between the highest and lowest levels of fidelity for the simulator. In operation, high-fidelity simulators typically require more processing and generally operate at slower speeds, whereas low-fidelity simulators require less processing and generally operate at higher speeds.

According to some examples, the hardware simulation framework may utilize different types of virtual machines, including persistent virtual machines and transitory virtual machines. Persistent virtual machines may be long-lived VMs that may be connected to a wider distributed network. Transitory VMs may be short-lived VMs that can be spun up faster but lack access to external hardware systems. Both persistent VMs and transitory VMs (collectively referred to herein as "VMs") may be brought up or torn down quickly as needed. The VMs may be created after the hardware requirements become known, independent of the platform development cycle. Also, multiple independent users may instantiate VMs on a single host device (e.g., server) or across multiple host devices. The VMs instantiated by the different users will not directly affect one another, nor will the VMs overburden the host device(s) if VMs are used to solve a problem found on the physical hardware and VMs do not interfere with each other.

According to some examples, the hardware simulation framework may allow for the injection of deterministic hardware errors such as memory corruption into the hardware simulation framework to perform testing, such as fault handling and fault recovery. As the errors may be found in the emulated hardware, such errors may be fixed without manually intervening in the development of the hardware.

According to some examples, the hardware simulation framework may allow for a configurable level of abstraction allowing multiple users to adjust speed and fidelity while testing each user's software on the hardware platform under development. The hardware simulation framework may also allow for the simulation of interconnected multi-node platforms. One or more users may connect to individual nodes or view the entire hardware system as a "black box". The simulated framework may be connected to a larger framework to test operations on a distributed hardware system and identify problems in the distributed hardware system if any are present.

According to some examples, the simulation framework may generate simulations from an entity-relationship model description of a desired system. An entity-relationship model may refer to a model that may represent relationships among objects, places, concepts, or events within an information technology system. For example, an entity-relationship model may provide diagrams depicting relationships between concepts and the hardware components that a user may want to connect to a distributed hardware system. An entity-relationship model may allow the framework to classify and interrelate each hardware component in a specific hardware system.

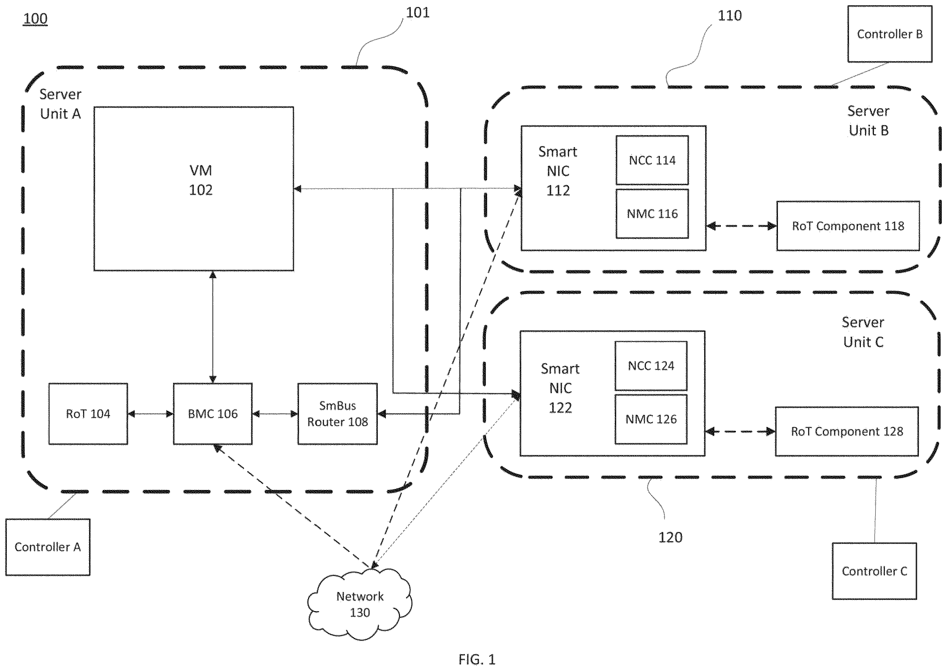

FIG. 1 depicts a high-level architecture of an example virtualized extensible hardware simulation configuration on a distributed network. As shown, VM 102, root of trust (RoT) 104, baseboard management controller (BMC) 106, and system management bus (SmBus) Router 108 may be grouped together by application programming interface (API) interface 101 and operate as a server unit A. Smart NIC 112 and RoT component 118 may be grouped as a unit by API interface 110 (Server unit B). Smart NIC 122 and RoT component 128 may be grouped as a unit by API interface 120 (Server unit C). Server units A-C may communicate through network 130. Each of the server units A-C may be controlled by a common controller, controllers A-C.

VM 102 is a virtual machine running on a particular host machine Through VM 102, a user may configure or test various components such as RoT 104, BMC 106, SmBus Router 108, and Smart NIC 112-122. According to some examples, a user may use a special type of user interface or API to emulate or simulate each component.

VM102 may communicate with emulated BMC 106. BMC 106 may be a baseboard management controller which may monitor the physical state of hardware, network service, or computer devices using sensors. BMC 106 may monitor temperature, humidity, power supply voltage, fan speeds, remote access, and operating system functions of the hardware.

Emulated BMC 106 may also monitor the physical state of smart NIC 112 and 122 using emulation via network 130. Emulated BMC 106 may monitor the physical state using emulated smart NIC 112-122.

RoT 104 may be a hardware root of trust which may contain keys used for cryptographic functions. RoT 104 may enable a secure boot process. RoT 104 may be simulated or emulated. RoT 104 may comprise various components such as components performing security-related functions including verification, reporting, updating, etc. RoT 104 may verify any software system before execution on server unit A or provide security measures for input and output between BMC 106 and VM 102. In some examples, each component may be configured with a composable set of configurations defined using a special user interface, such that a generic RoT configuration included along with platform-specific components may be provided to multiple platform-specific configurations, which may allow for maximum flexibility and reusability.

SmBus Router 108 may include a system management bus that provides an interaction between the host device of VM 102 and the devices of other network devices such as smart NIC112 and smart NIC 122, such that they can be monitored by each other.

Server unit B may comprise smart NIC 112 including NIC compute complex (NCC) 114 and NIC management controller (NMC) 116.

Server unit B may comprise smart NIC 112 including NCC 114 and NMC 116. NIC 112 may communicate with RoT component 118. Server unit C may comprise smart NIC 122 including NCC 124 and NMC 126. Smart NIC 122 may interact with RoT component 128. RoT components 118 and 128 may monitor and provide security measures to smart NICs 112 and 122 especially when they communicate with VM 102 such that any input/output to or from VM 102 may be monitored and protected from security-threatening activities or transactions.

Smart NICs 112 and 122 are smart network interface cards capable of delivering accelerated, hardware-based network and security capabilities for cloud computing frameworks. Smart NIC 112 and 122 may communicate with VM 102 via SmBus Router 108. NCC 114 and 124 are compute units comprising one or more registers for short-term, intermediate storage of data and provide offloading compute for NIC 112-122. NMC 116 and 126 are controllers that manage the operations of NIC 112-122.

VM 102 and SmBus Router 108 may be simulated using software provisioning both hardware and software framework. RoT 104, BMC 106, NCC 114 and 124, NMC 116 and 126 and RoT components 118 and 128 may be emulated running the real software binaries. Host software has the logic to run a test in an emulated framework, which may also create one or more guest VMs and enable such VMs to run a test on emulated hardware that may encompass various components of each different server unit.

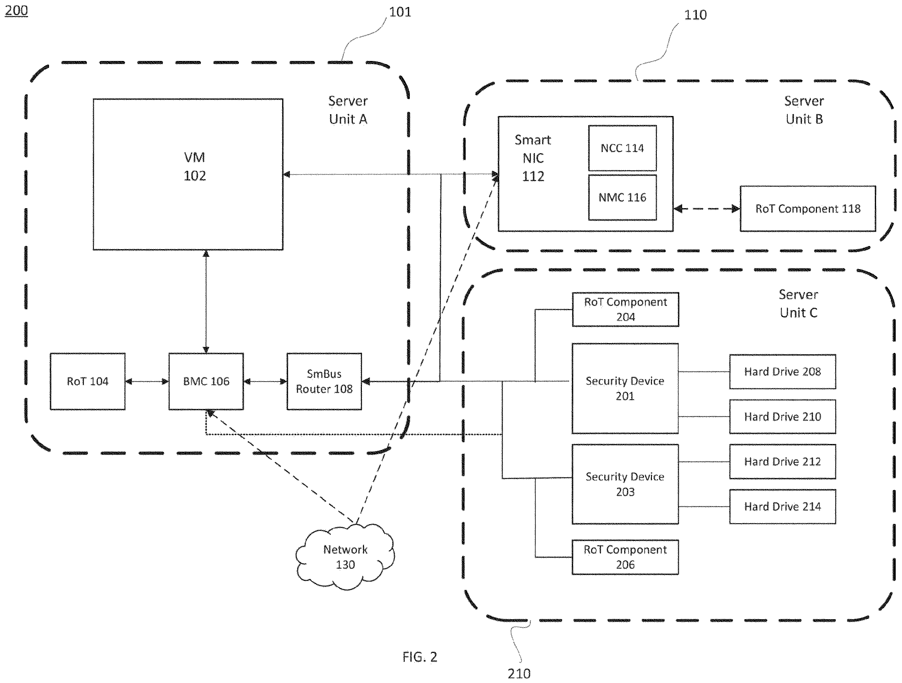

Figure 2 depicts an example virtualized extensible hardware simulation framework200 used to interconnect multiple storage devices in a cloud framework As described in reference to Figure 1, Smart NIC 112 may directly communicate with host VM 102 or via SmBus Router 108. Server unit C includes one or more security devices such as security devices 201 and 203 connected to multiple hard drives 208-214. RoT components 204 and 206 may provide security measures or monitor the activities of security devices 201 and 203.

Security devices 201 and 203 may be an application-specific integrated circuit (ASIC) for the sole purpose of managing and providing user identification codes, digital certificates, authentication codes or such other security-related information. Hard drives 208-214 are any type of storage including solid state drives (SSD) and hard disk drives (HDD) used for data center storage. BMC 106 may monitor the temperature, humidity, power supply voltage, fan speeds, remote access, and operating system functions of security devices 201 and 203.

According to some examples, parts of the hardware simulation framework 200 may be configured to be emulated and other parts may be simulated. Configuration of each component may be easily modified by a user using a user interface connected to VM 102. RoT Components 204 and 206 and security devices 201 and 203 may be emulated and hard drives 208-214 may be simulated. As security devices 201 and 203 may be emulated, host VM 102 may communicate with security devices 201 and 203 through SmBus router 108 or any other type of remote procedure calls (RPCs) using PCIe or USB. For example, if a higher level of accuracy on security devices 201-203 but a lower level of accuracy on hard drives 208-214 is desired by a user, the user may configure using VM 102 to emulate security devices 201-203 and simulate hard drives 208-214.

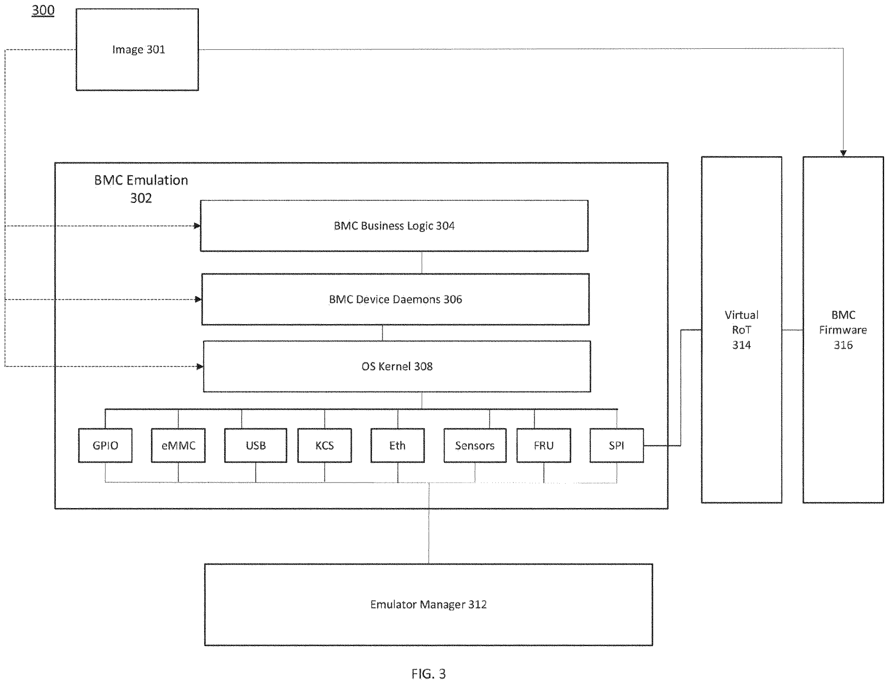

Figure 3 depicts a block diagram of an example emulation of a baseboard management controller (BMC). BMC emulation 302 contains BMC business logic 304, BMC device daemons 306, and Operating System (OS) kernel 308. Image 301 may be an image of underlying hardware being developed or built. Image 301 may interact with a real BMC (not shown in Figure 3) through BMC firmware 316.

BMC firmware 316 may be any type of embedded software located on BMC. Image 301 may send information on the underlying hardware to BMC business logic 304, BMC device daemons 306, and OS kernel 308. The OS kernel may control various components as shown in Figure 3. For example, OS kernel 308 has direct access to general-purpose input/output (GPIO), embedded multimedia card (eMMC), universal serial bus (USB), keyboard controller style (KCS), Ethernet (Eth), sensors, a field replacement unit (FRI), and serial peripheral interface (SPI).

Emulator manager 312 may have access to the various components. Emulator manager 312 may interact with virtual RoT 314. Virtual RoT 314 may protect the security of these components. As shown in Figure 2, host VM 102 may interact with emulation manager 312 to test and control the BMC.

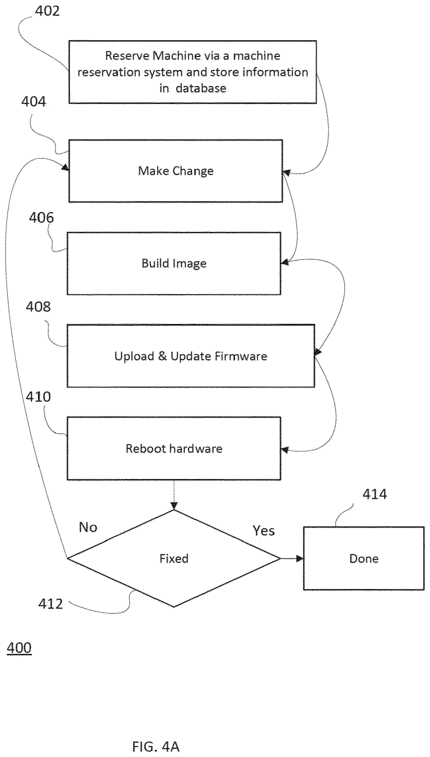

Figure 4A depicts a flow diagram of example functional tests using physical hardware. According to block 402, a machine or hardware under development may be reserved in a database specialized for machine reservation. The aforementioned database specialized for machine reservation may be used to store all existing tools used for emulated environments. For example, a smart network interface card (NIC) may be under development, and a user may want to test the physical smart NIC while it is being developed - that is, a prototype of the smart NIC may be tested. The information of the smart NIC may be reserved in a database such as memory 604, such that the information may later be used by a user for simulation. Such information may allow the user to request a machine stored in the machine reservation with specific attributes.

According to block 404, changes may be made to software component on a virtual machine. For example, the user may test a particular firmware associated with the smart NIC using a virtual machine. The virtual machine allows the user to test the firmware on a simulated smart NIC and find errors. The user may change the firmware to correct the errors.

According to block 406, the changes may be saved, and images may be built based on the saved changes. For example, the user may change the firmware operating on the smart NIC. Since the changes were made to the firmware based on the simulated smart NIC, the change needs to be stored.

According to block 408, the built image may be used to update the firmware of the hardware device. For example, the image of the changed firmware stored in the database may be retrieved and the actual firmware of the smart NIC may be changed according to the image of the changed firmware stored in the database.

According to block 410, the hardware may be rebooted to start the update function of the firmware. For example, the changes in the firmware were made by the user in an attempt to fix an error. If the rebooted hardware is fixed for the previously identified errors or issues, the process finishes at block 414. If not, the process goes back to block 404 and a new change may need to be made by the user using the firmware.

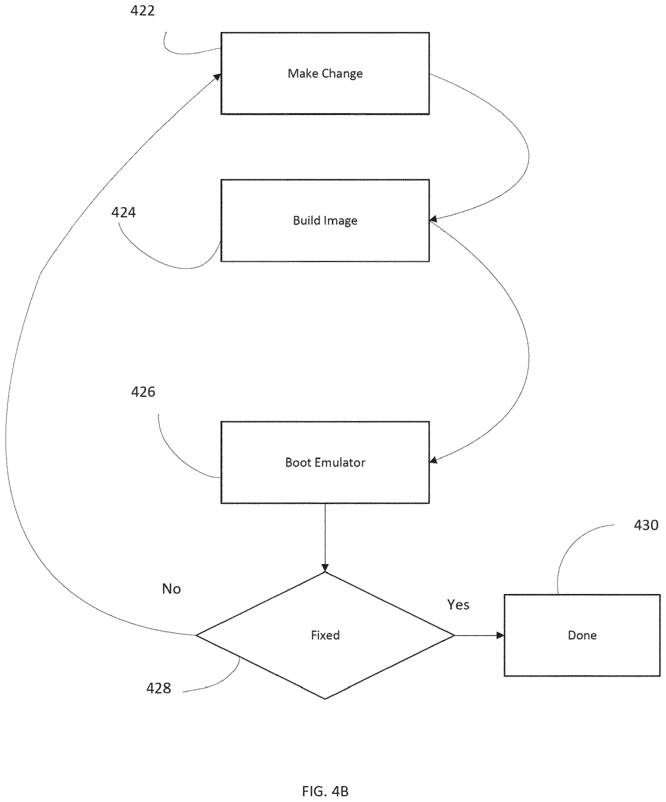

In contrast, Figure 4B depicts a flow diagram illustrating the development of underlying hardware using an emulator and a virtual machine. According to block 422, the user may want to test a particular firmware associated with the same smart NIC using a virtual machine. The virtual machine allows the user to test the firmware on a simulated smart NIC and find errors. The changes may be made using the same firmware as in the above example on a virtual machine. According to block 424, the change made on the firmware may be saved.. According to block 426, instead of directly uploading the changes to the firmware of the underlying hardware, the emulator may be booted. For example, the emulator that emulates the underlying hardware restarts and determines whether the error has been fixed by the change. If the error is fixed, the process may finish at block 430. If not fixed, the process returns to block 422 to allow the user to make additional changes to fix the same error.

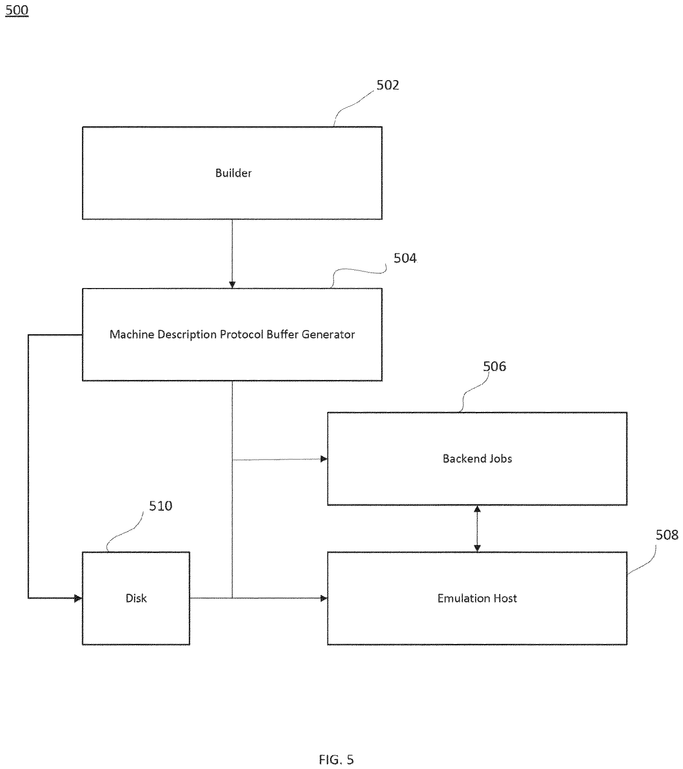

Figure 5 depicts a flow diagram illustrating an example simulation flow of a host machine. According to block 502, builder may send various information to a framework generator. Such information may include information about system management, basic input/output system, PCI topology, BMC, PCI trays, and golden reference model(s) (GRMs). According to block 504, a framework for a VM may be configured. According to block 506, backend jobs may be started after the VM framework wires up the configuration with any port mappings. According to block 508, the VM may start the host machine and may launch a test using software on the VM. Any specific hardware configuration may be stored in the disk at block 510.

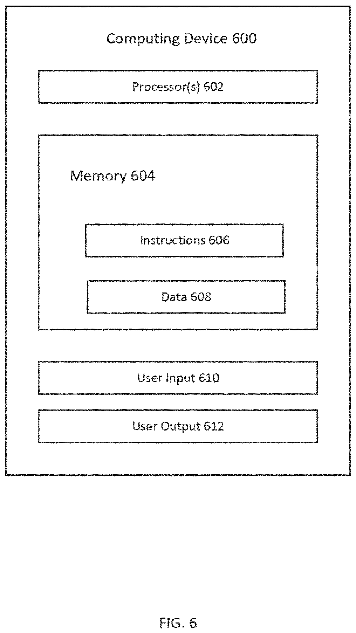

Figure 6 illustrates a computing device. Computing device 600 may include processor 602, memory 604, user input 610, and user output 612. Memory 604 may include instructions 606 and data 608. Memory 604 may store information accessible by processor 602 including instructions 606 that can be executed by processor 602. Processor 602 may also retrieve, manipulate or store data 608. Processor 602 may include one or more central processing units (CPUs), graphic processing units (GPUs), field-programmable gate arrays (FPGAs), and/or application-specific integrated circuits (ASICs), such as tensor processing units (TPUs). According to aspects of this disclosure, processor 602 and memory 604 may be either emulated or simulated and tested using a VM.

According to some examples, a user may select fidelity for the components the user wants to simulate via user input 610. User input 610 may be received via a graphic user interface. User input 610 may be processed by processor 602. Processor 602 may simulate various components according to the user's selection of fidelities. Processor 602 may run the simulation of the various components and the user may test the various components using the simulations generated by processor 602. Any outcome of the test performed on the simulated components by the user may be output as user output 612. User input 610 and user output 612 may be stored in memory 604.

Instructions 606 can include one or more instructions that when executed by processor 602, cause one or more processors to perform actions defined by the instructions, such as simulating various types of hardware. The instructions 606 can be stored in object code format for direct processing by the processor 602, or in other formats including interpretable scripts or collections of independent source code modules that are interpreted on demand or compiled in advance. Instructions 606 can include instructions for implementing processes consistent with aspects of this disclosure. Instructions 606 may include instructions for implementing a user interface that may allow a user to change configurations of emulators and simulators for various components within computing device 600 or any type of hardware communicative with computing device 600.

Data 608 may include information collected using emulation and simulation of various components within computing device 600 or external devices that may interact with computing device 600. Data 608 can be retrieved, stored, or modified by processor 602 in accordance with instructions 606. Data 608 can be stored in computer registers, in a relational or non-relational database as a table having a plurality of different fields and records, or as JSON, YAML, Protocol Buffers, or XML documents. Data 608 can also be formatted in a computer-readable format such as, but not limited to, binary values, ASCII, or Unicode. Moreover, data 608 can include information sufficient to identify relevant information, such as numbers, descriptive text, proprietary codes, pointers, references to data stored in other memories, including other network locations, or information that is used by a function to calculate relevant data.

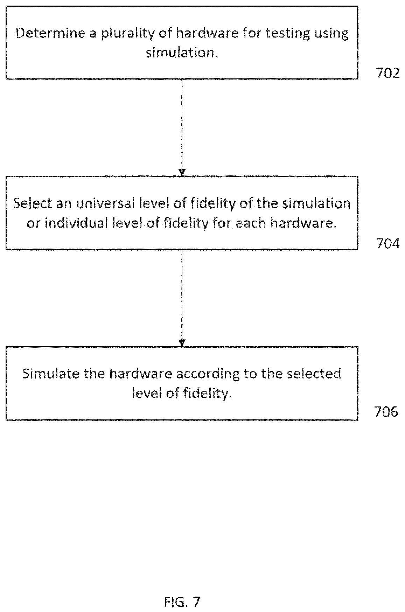

FIG. 7 depicts a flow diagram of an example method for hardware simulation. According to block 702, a plurality of hardware components is identified for testing simulation. For example, the hardware components may include a baseboard management controller, router, NIC, and other miscellaneous components such as general-purpose input/output (GPIO), embedded multimedia card (eMMC), universal serial bus (USB), keyboard controller style (KCS), Ethernet (Eth), sensors, a field replacement unit (FRU), and serial peripheral interface (SPI).

According to block 704, a level of fidelity of the simulation is selected. According to some examples, a user may interact with a graphical user interface to modify or adjust the level of fidelity of the simulation for each hardware component. In some examples, the level of fidelity may be set universally (the same for each hardware component or groups of hardware components) or for each hardware component individually. For example, a user may select high accuracy (high fidelity) for one hardware component and select low accuracy (low fidelity) for another hardware component. The user may also select a level of fidelity somewhere between the highest and lowest levels of fidelity for the hardware components.

According to block 706, the hardware components are simulated according to the selected level of fidelity. Each hardware component may be simulated using the level of fidelity selected for that component. For example, if a high level of fidelity is selected for a first hardware component, the first hardware component is simulated using a high level of fidelity. In another example, if a mid-level of fidelity is selected for a second hardware component, the second hardware component is simulated using the mid-level of fidelity. Simulations of hardware components assigned a higher level of fidelity may require more resources and take more time than simulations of hardware components assigned a low level of fidelity, as lower fidelity simulations require fewer resources and can be processed at a higher speed.

Although the technology herein has been described with reference to particular examples, it is to be understood that these examples are merely illustrative of the principles and applications of the present technology. It is, therefore, to be understood that numerous modifications may be made and that other arrangements may be devised without departing from the spirit and scope of the present technology as defined by the appended claims.

Unless otherwise stated, the foregoing alternative examples are not mutually exclusive but may be implemented in various combinations to achieve unique advantages. As these and other variations and combinations of the features discussed above can be utilized without departing from the subject matter defined by the claims, the foregoing description should be taken by way of illustration rather than by way of limitation of the subject matter defined by the claims. In addition, the provision of the examples described herein, as well as clauses phrased as" "such as," "including," and the like, should not be interpreted as limiting the subject matter of the claims to the specific examples; rather, the examples are intended to illustrate only one of many possible implementations. Further, the same reference numbers in different drawings can identify the same or similar elements.

## Claims

1. A system for hardware simulation framework, comprising:
one or more computing devices configured to:
determine a plurality of hardware devices for testing using simulation;
enable a user to select a level of fidelity of the simulation for each of the plurality hardware devices; and
simulate each of the plurality of hardware devices based on the selected level of fidelity.

2. The system of claim 1, wherein the system further comprises a plurality of virtual machines and a virtual machine orchestrator.

3. The system of claim 1, wherein the level of fidelity of the simulation for each of the plurality of hardware devices is determined based on desired processing speed and accuracy of the simulation of each hardware device.

4. The system of claim 1, wherein the fidelity levels are changed using a graphical user interface or text files, wherein the system optionally further comprises a simulation builder, wherein the simulation builder automatically simulates each of the plurality of hardware devices based on the entity-relationship model.

5. The system of claim 1, further comprising an entity-relationship model, wherein the entity-relationship model describes configurations of the plurality of hardware devices, wherein, optionally, the simulated each of the plurality of hardware devices are integrated into a distributed production software stack and network.

6. The system of claim 1, wherein each of the simulated hardware devices mimic functions of each of the hardware devices.

7. The system of claim 1, wherein each of the simulated hardware devices are either partially simulated or fully simulated.

8. The system of claim 1, wherein the simulated hardware devices are connected to the hypervisor via an application programming interface, API, layer.

9. The system of claim 2, wherein each of the virtual machines is either a persistent virtual machine or a transitory virtual machine.

10. The system of claim 2, wherein the virtual machine orchestrator utilizes a remote procedure call, RPC, to enable interaction between the plurality of virtual machines using different languages in different manners.

11. The system of claim 2,
wherein the virtual machine orchestrator communicates with one or more simulated hardware devices using smart network interface cards in the network, wherein the smart network interface cards can be simulated based on a user selection; and/or
wherein the virtual machine orchestrator provides a configurable level of abstraction, for the simulation; and/or
wherein the virtual machine orchestrator is further configured to inject deterministic errors of the hardware devices into the simulated hardware devices for testing errors.

12. The system of claim 2, wherein the virtual machine orchestrator is further configured to simulate a baseboard management controller to manage a physical state of the hardware devices.

13. The system of claim 12, wherein the physical state of the hardware devices comprises temperature, humidity, power supply voltage, fan speeds, remote access, and operating system functions of the underlying hardware.

14. A method for hardware simulation framework, the method comprising:
determining, by one or more processors, a plurality of hardware devices for testing using simulation;
enabling, by the one or more processors, a user to select a level of fidelity of the simulation for each of the plurality hardware devices; and
simulating, by the one or more processors, each of the plurality of hardware devices based on the selected level of fidelity.

15. The method of claim 14,
wherein the level of fidelity of the simulation for each of the plurality of hardware devices is determined based on desired processing speed and accuracy of the simulation of each hardware device; and/or
wherein the fidelity levels are changed using a graphical user interface or text files.
